# EUROPEAN PATENT APPLICATION

(11) **EP 1 814 226 A1**
(43) Date of publication of application: **01.08.2007**
(21) Application number: 06001155.8
(22) Date of filing: 19.01.2006
(51) Int. Cl.: H03K 17/955

(54) **Capacitive sensor film and method for manufacturing the same**

(71) Applicant: 3M Innovative Properties Company, St. Paul, Minnesota 55133-3427 (US)
(72) Inventor: Douglas, Malcom, Swansea SA3 2DP Wales (GB)
(74) Representative: Wilhelm, Stefan

(57) **Abstract**

The present invention relates to a capacitive sensor film providing a sensor conductor by removing zones of said front conductor at least partly surrounding said sensor conductor by laser ablation to electrically isolate the sensor conductor from said front conductor thereby exposing the front major surface of the backing layer or another layer beneath the front conductor in said zones.

## Description

### Field of the invention

The present invention relates to a capacitive sensor film suitable for being mounted to a body such as, for example, the rear side and/or bumper of a vehicle. The present invention also relates to an improved method for manufacturing such capacitive sensor films.

### Background of the invention

Capacitive sensor devices which are also referred to as capacitive proximity sensors have been used in various industrial applications for locating the presence of materials and for avoiding collisions with articles. In one field of application, capacitive proximity sensors have been fitted, for example, with the rear side and/or bumpers of cars. When the vehicle is reversed a warning signal is provided when the car approaches an object so that a collision can be safely avoided while still allowing the driver to conveniently position the car close to such object.

GB 2,400,666 discloses a capacitive proximity sensor comprising a substrate bearing two metal plates on its opposite major surfaces. The capacitive proximity sensor can be provided inside the bumper of a vehicle. The metal plate facing outwardly is referred to as the sensor conductor whereas the metal plate facing the car body is called the guard conductor. The sensor conductor is screen-printed with conductive ink onto the substrate whereas the guard conductor may be a metal strip. The guard conductor is typically larger than the sensor conductor and provides a shield between the sensor conductor and the car body. The change of the capacitance between the sensor conductor and ground is monitored and provides an indication for the distance between the car and an object outside of the car.

GB 2,374,422 addresses the problem of reducing the effect of the presence of water as caused, for example, by steady rain on the sensitivity of the capacitive proximity sensor. In one embodiment it is suggested to arrange an extra conductive plate on the major side of the substrate bearing the sensor conductor. The extra conductive plate which can be arranged on the sensor conductor side above or below said sensor conductor or both (with respect to the level of the street) is often referred to as superguard conductor. In operation, an amplified guard signal is applied to the superguard conductor which has the effect of making the guard appear bigger. The superguard conductor is effective in attenuating or minimizing capacitance changes resulting from drips of water running across the front of the sensor. A capacitive proximity sensor comprising a superguard conductor is also disclosed in GB 2,404,443.

The guard conductor acts as a shield to reduce the sensitivity of the sensor conductor and, if present, the superguard conductor to anything behind it in the direction of the body. Therefore the dimensions of the guard conductor are typically chosen to exceed those of the sensor conductor and, if present, of the superguard conductor. GB 2,400,666 discloses, for example, a capacitive sensor film wherein the guard conductor is formed by an aluminum strip which preferably fully covers the rear major surface of the substrate.

While for guard conductors the dimensional extension may be an important design criterion their geometrical shape usually is less critical. Contrary to this, the zones of the sensor conductor and, if present, of the superguard conductor, are typically smaller than that of the substrate whereas their respective sensitivity may depend on their geometrical shape.

GB 2,348,505 discloses, for example, a sensor conductor geometry where the end regions of such conductor may be wider than its central region. This tends to improve the sensitivity of the capacitive proximity sensor at the corners of the vehicle.

The co-pending European patent application with the title "Proximity sensor and method for manufacturing the same" which was filed by the present applicant on January 19, 2006 discloses a sensor conductor comprising a sequence of strips essentially extending in the longitudinal direction of the substrate. The strips may be formed by optionally flattened metal wires or strips of a metal foil. The strips may be arranged essentially parallel to each other whereby another strip is preferably provided in a transverse direction to electrically connect the strips or wires in the longitudinal direction. This sensor design has an especially advantageous sensitivity.

Only a limited number of geometries and designs of sensor conductors and superguard conductors, respectively, have been described in the prior art so far. The methods of manufacturing capacitive sensor films comprising sensor conductors and/or superguard conductors with a geometry designed to improve the sensitivity of the capacitive sensor film include adhesion bonding of metal strips which may not meet all production requirements.

Accordingly it is an object of the present invention to provide a capacitive sensor film which does not exhibit the shortcomings of the state-of-the-art devices or exhibits them to a low degree only, respectively. It is another object of the present invention to provide capacitive sensor films comprising alternative and/or improved designs of the sensor conductor and/or the superguard conductor. It is another object of the present invention to provide a method of manufacturing capacitive sensor films with allow for providing a broad variability of designs and geometries of the sensor conductor and the superguard conductor.

Other objects of the present invention can readily be taken from the following detailed description

### Summary of the invention

The present invention relates to a capacitive sensor film capacitive sensor film for mounting to a body comprising a backing layer having a rear major surface facing, in use, the body and a front major surface opposite to said rear major surface, said rear major surface bearing a guard conductor and said front major surface bearing a front conductor at least partly surrounding a sensor conductor which is electrically isolated against the front conductor by zones where the front conductor is removed and the front major surface of the backing layer or another layer beneath the front conductor is exposed.

The present invention furthermore relates to another method of manufacturing a capacitive sensor film according to the invention comprising
(i) providing a backing layer,
(ii) applying a guard conductor to the rear major surface of the backing layer,
(iii) applying a front conductor to the front major surface of the backing layer,
(iv) providing a sensor conductor by removing zones of said front conductor at least partly surrounding said sensor conductor by laser ablation to electrically isolate the sensor conductor from said front conductor thereby exposing the front major surface of the backing layer or another layer beneath the front conductor in said zones.

The present invention furthermore relates to a method of manufacturing a capacitive sensor film according to the invention comprising
(i) providing a backing layer,
(ii) applying a guard conductor to the rear major surface of the backing layer,
(iii) applying a front conductor to the front major surface of the backing layer,
(iv) providing a sensor conductor by mechanically abrading zones of said front conductor at least partly surrounding said sensor conductor to electrically isolate the sensor conductor from said front conductor thereby exposing the front major surface of the backing layer or another layer beneath the front conductor in said zones.

The present invention furthermore relates to the use of the capacitive sensor film of the present invention for automotive applications.

### Brief description of the figures

*Figs. 1 and 1a* show top views of two embodiments of a capacitive sensor film 50 of the present invention.
*Figs. 2 and 2a* are cross-sectional views of two different embodiments of the capacitive sensor film 50 of Fig. 1a along the line A-A indicated in Fig. 1a.
*Figs. 3a - 3c* show the top view of the left part of the capacitive sensor film 50 of Fig. 1a additionally comprising two through-going holes 10 applied in the connector zones 8 of the superguard conductor 5 and the top-most strip of the sensor conductor 7, respectively.
*Figs. 4* is a cross-sectional views of the capacitive sensor film 50 of Fig. 3c along the line B-B indicated in Fig. 3c.
*Fig. 5* is the cross-sectional view of the capacitive sensor film 50 of Fig. 4 additionally comprising two protective layers 16, 17.
*Fig. 6* is the top view of a capacitive sensor film 50 similar to the embodiment of Fig. 3c which comprises a further through-going hole 10.
Fig. 6a is a cross-sectional view of the capacitive sensor film 50 of Fig. 6 along the line C-C indicated in Fig. 6.

### Detailed description of the invention

The term film as used above and below refers to an article having an extension in two directions which exceed the extension in a third direction which is essential normal to said two directions by a factor of at least 5 and more preferably by at least 10. The term film as used above and below includes sheetings, foils, strips, laminates, ribbons and the like.

The term electrically isolating as used above and below refers to materials having a specific bulk resistivity as measured according to ASTM D 257 of at least 1 x 10¹² Ωcm and more preferably of at least 1 x 10¹³ Ωcm. The term electrically conductive as used above and below refers to materials having a surface resistivity as measured according to ASTM B193-01 of less than 1 Ω/cm².

The capacitive sensor film 50 of the present invention comprises an electrically isolating backing layer 2 bearing on one of its major surfaces 2a a guard conductor 1 and on its opposite major surface 2b a sensor conductor 7.

The backing layer is preferably continuous and preferably has a thickness of between 20 - 200 µm and more preferably of between 25 - 150 µm. Suitable backing materials include, e. g., polymeric films and layers, paper films and layers, layers of non-wovens, laminates (such as, for example, polyacrylate foams laminated on both sides with polyolefin films, and papers laminated or jig-welded with polyethylene terephthalate) and combinations thereof. Useful polymeric films and layers include, for example, polyolefin polymers, monoaxially oriented polypropylene (MOPP), biaxially oriented polypropylene (BOPP), simultaneously biaxially oriented polypropylene (SBOPP), polyethylene, copolymers of polypropylene and polyethylene, polyvinylchloride, copolymers having a predominant olefin monomer which may be optionally chlorinated or fluorinated, polyester polymers, polycarbonate polymers, polymethacrylate polymers, cellulose acetate, polyester (e. g. biaxially oriented polyethylene terephthalate), vinyl acetates, and combinations thereof. Useful backings also include surface modified backings modified by, e. g., plasma discharge techniques including corona discharge treatment and flame treatment, mechanical roughening and chemical primers.

The guard conductor 1 comprises an electrically conductive material preferably including one or more metals which are applied as a layer or a film to one of the major surfaces of the backing layer 2. Especially preferably the guard conductor 1 comprises an aluminium layer. The guard conductor may be formed, for example, by a metal film which is bonded to such major surface of the backing layer 2 with an adhesive layer 3 such as, for example, a pressure-sensitive adhesive layer. The guard conductor 1 may also be directly applied to such major surface of the backing layer 2, for example, by vacuum metal vapour deposition.

The thickness of the guard conductor 1 may vary widely depending on the method of manufacturing it. A guard conductor layer 1 obtained by vacuum metal vapour deposition may be as thin as 200 - 800 Å and more preferably 300 - 500 Å. When using an aluminum film or foil as a guard layer 1 it may have a thickness of from 1 - 50 µm, more preferably 2 - 30 µm and especially preferably 3 - 15 µm.

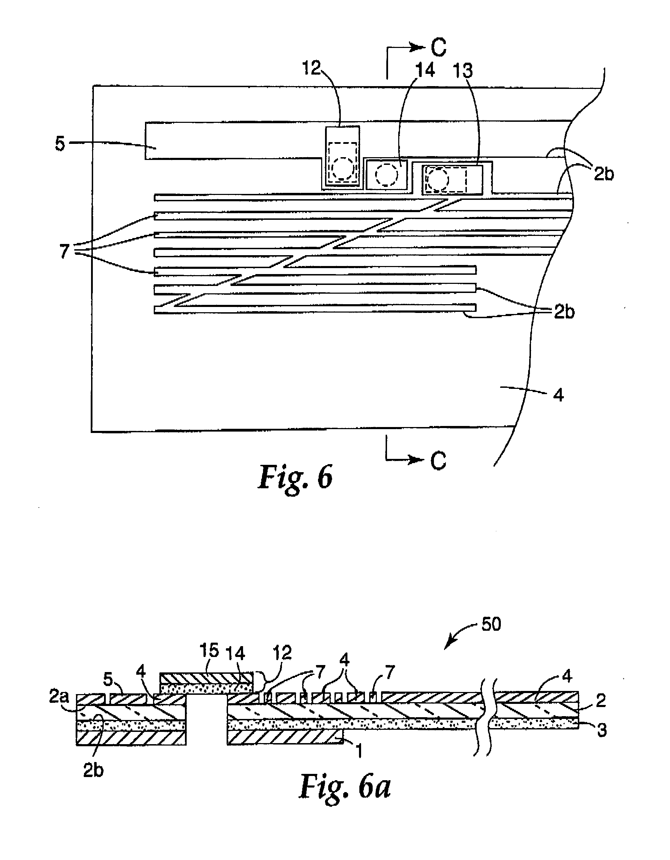

In the capacitive sensor films 50 of the present invention the front conductor 4 can be electrically connected with the guard conductor 1. A preferred construction is shown, for example, in the embodiment of Fig. 6a which shows a cross-sectional view of the capacitive sensor film of Fig. 6 along line C-C indicated in Fig. 6. It can be taken from the cross-sectional view of Fig. 6a that a through-going hole 10 has been applied extending from the front major surface of the front conductor 4 through the capacitive sensor film 50 to the rear major surface of the guard conductor 1. A strip of an auxiliary connector adhesive tape 12 comprising, for example, a metal film backing 15 and an electrically conductive pressure-sensitive adhesive 14 is attached to the front conductor 4 so that it covers the through-going hole 10. If desirable, the through-going hole 10 can be filled with a conductive ink electrically connecting the front conductor 4 and the guard conductor 1 so that these can be contacted from the rear major surface of the capacitive sensor film 50. Alternatively it is, for example, also possible to mechanically connect the guard conductor 1 and the electrically conductive adhesive strip 12.

The guard conductor 1 which is optionally connected to the front conductor 4 acts as a shield to reduce the sensitivity of the sensor conductor 7 to anything behind it in the direction of the body. In automotive applications, for example, it is desirable that the sensor conductor 7 detects objects that are generally outward of the vehicle but is substantially less sensitive and, preferably, substantially blind towards the inside of the vehicle.

Therefore the dimensions of the guard conductor 1 or, optionally, the joint dimensions of the guard conductor 1 and the front conductor 4 if these are electrically connected, are preferably chosen to match at least those of the sensor conductor 7 but it is more preferred that the dimensions of the guard conductor 1 or, optionally, the joint dimensions of the guard conductor 1 and the front conductor 4 exceed at least partly those of the sensor conductor 7.

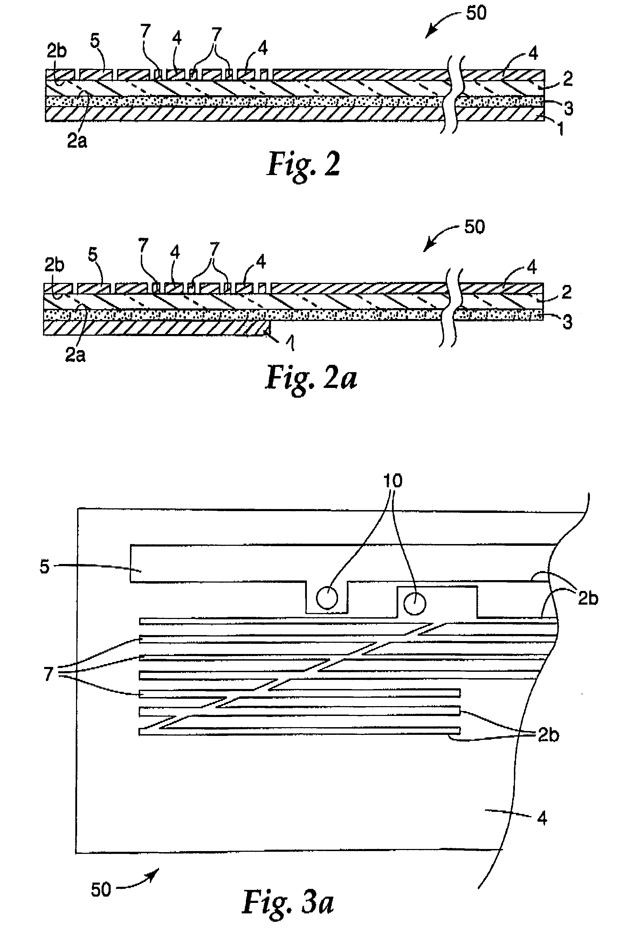

In an especially preferred embodiment the guard conductor 1 essentially fully covers the major side of the backing layer 2 it is attached to as is shown, for example, in Fig. 2. In an alternative especially preferred embodiment the guard conductor 1 is electrically connected to the front conductor 4 so that the combination of the guard conductor 1 and the front conductor 4 essentially fully matches the dimensional extension of the backing layer 2 as is shown, for example, in Fig. 2a.

The front major surface 2b of the backing layer 2 which is opposite to the rear major surface 2a bearing the guard conductor 1 bears a front conductor 4.

The front conductor 4 comprises an electrically conductive material and preferably one or more metals. In a preferred embodiment the front conductor 4 comprises a relatively cheap material such as an aluminium layer which may be applied by vacuum metal vapour deposition or as an aluminium film or foil which can be bonded to the backing 2, for example, by an adhesive layer 3 such as, for example, a pressure-sensitive adhesive layer. In another preferred embodiment the front conductor 4 comprises a copper layer which can be applied, for example, by vacuum metal vapour deposition or as an adhesively bonded copper film or foil.

The thickness of the front conductor 4 may vary widely depending on the method of manufacturing it. Front conductors comprising metal films such as, for example, an aluminium foil may have a thickness of from 1-50 µm, more preferably 2 - 30 µm and especially preferably 3 - 15 µm. Front conductors 4 obtained by vacuum metal vapour deposition may be as thin as 200 - 800 Å and more preferably 300 - 500 Å.

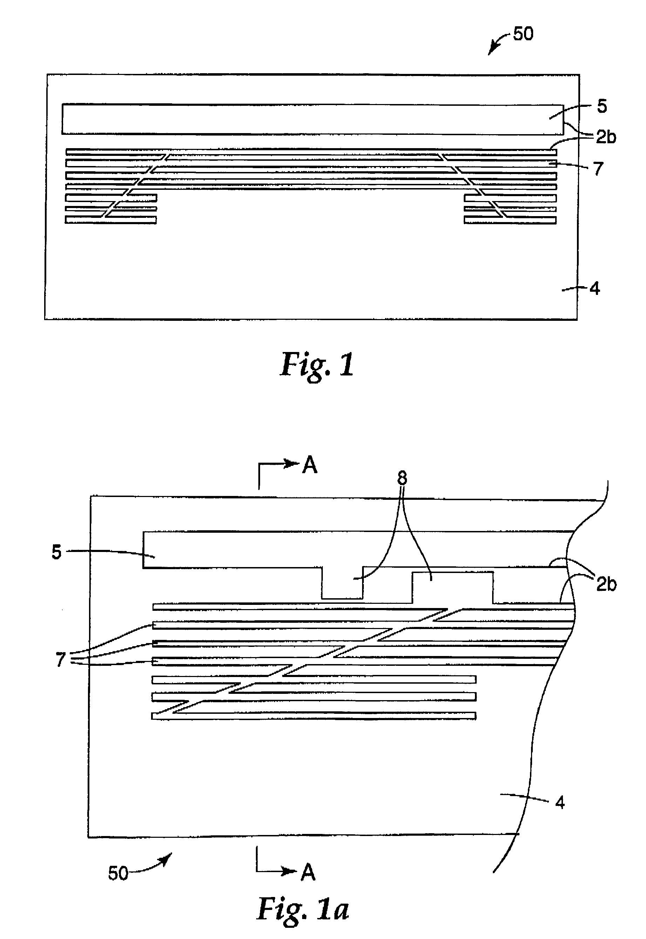

In the present invention a sensor conductor 7 is formed by removing the front conductor 4 in zones at least partly surrounding the sensor conductor to an extent to electrically isolating the sensor conductor 7 from the front conductor 4. In some cases the front conductor 4 may completely surround the sensor conductor 7 as is shown, for example, in the embodiment of Fig. 1 where the white zone represents the metal conductor 4, i. e. the metal conductor 4 fully covers the front major surface 2b of the backing layer 2. In other cases where the front conductor 4, for example, covers only part of the front major surface 2b of the backing layer 2 or where the sensor conductor 7 is arranged at an edge of the front conductor 4, the front conductor 4 may only partly surround the sensor conductor 7.

The front conductor 4 is removed in the zones at least partly surrounding the sensor conductor to an extent to electrically isolate the sensor conductor 7 against the front conductor 4. Preferably the front conductor 4 is completely removed in such zones. If the front conductor 4 comprises a metal layer which is directly applied, for example, by means of vacuum metal vapour deposition onto the front major surface 2b of the backing layer 2 removal of the front conductor 4 will preferably result in exposing the front major surface 2b in said zones as is schematically illustrated, for example, in Figs. 1 and 2. If the front conductor 4 comprises a metal film or foil which is applied to the front major surface 2b of the backing layer 2, for example, by means of an adhesive layer 3 removal of the front conductor 4 will preferably result in exposing the adhesive layer 3 and/or the front major surface 2b in said zones. In other constructions of the capacitive sensor film of the present invention other layers arranged beneath the front conductor 4, may be exposed.

The capacitive sensor film 50 of the present invention may additionally comprise a superguard conductor 5 which is preferably arranged on the surface of the backing 2 bearing the sensor conductor 7. In automotive applications the superguard conductor 5 may be arranged - relative to the road level - above or below the sensor conductor. In use, an amplified guard signal may be applied to the superguard conductor 5 which has the effect of making the guard appear bigger. According to GB 2,374,422, this may be effective in automotive applications when the proximity sensor 50 is assembled, for example in the rear-side bumper of a car, to minimize the effect of water drips running down in rainy weather conditions across the bumper, on the signal of the sensor conductor 7.

Like the sensor conductor 7, the superguard conductor 5 is preferably formed by removing the front conductor 4 in zones at least partly surrounding the superguard conductor 5 to an extent to reliably electrically isolating the superguard conductor 5 from the front conductor 4. The superguard conductor 5 is preferably arranged outside the zone of the sensor conductor 7 but may in some cases also be arranged within the zone of the sensor conductor 7. In such case the superguard conductor 5 is preferably formed by removing the sensor conductor 7 in zones at least partly surrounding the superguard conductor 5 to an extent to electrically isolating the superguard conductor 5 from the sensor conductor and from the front conductor 4.

In some cases the front conductor 4 may completely surround the superguard conductor 5 as is shown, for example, in the embodiment of Fig. 1 where the white zone represents the front conductor 4, i. e. the front conductor 4 fully covers the front major surface 2b of the backing layer 2. In other cases where the front conductor 4, for example, covers only part of the front major surface 2b of the backing layer 2 or where the superguard conductor 5 is arranged at an edge of the front conductor 4, the front conductor 4 may only partly surround the superguard conductor 5. Similarly, if the superguard conductor 5 is formed within the sensor conductor 7, the sensor conductor 7 may completely or partly surround the superguard conductor 5.

The front conductor 4 and/or the sensor conductor 7 are removed in the zones at least partly surrounding the superguard conductor 5 to an extent to electrically isolate the superguard conductor 5 against the front conductor 4 and/or the sensor conductor 7. Preferably the front conductor 4 andor the sensor conductor 7 are completely removed in such zones. If the front conductor 4 and/or the sensor conductor 7 comprise a metal layer which is directly applied, for example, by means of vacuum metal vapour deposition onto the front major surface 2b of the backing layer 2 removal of the front conductor 4 and/or the sensor conductor 7 will result in exposing the front major surface 2b in said zones as is schematically illustrated, for example, in Fig. 1 and 2. If the front conductor 4 and/or the sensor conductor 7 comprise a metal film or foil which is applied to the front major surface 2b of the backing layer 2, for example, by means of an adhesive layer 2 removal of the front conductor 4 may result in exposing the adhesive layer 3 and/or the front major surface 2b in said zones. In other constructions of the capacitive sensor film of the present invention other layers arranged beneath the front conductor 4, may be exposed.

The sensor conductor 7 and, if present, the superguard conductor 5 both comprise an electrically conductive material. Since the sensor conductor 7 and the superguard conductor 5 are preferably formed within the front conductor 4 by removing zones of the front conductor 4 at least partly surrounding said sensor conductor 7 and superguard conductor 5 the material comprised by the sensor conductor 7 and the superguard conductor 5 preferably corresponds to the material comprised by the front conductor 4. The sensor conductor 7 and the superguard conductor 5 are preferably formed by separate part zones of the front conductor 4 so that the material and the thickness of the sensor conductor 7 and the superguard conductor 5 preferably correspond to that of the front conductor 4.

The zones which are removed from the front conductor 4 and, if the superguard conductor 5 is formed within the sensor conductor 7, from the sensor conductor 7, and which are surrounding the sensor conductor 7 and, if present, the superguard conductor 5 may exhibit various dimensions and shapes. Preferably such zones are elongate channels having a width of preferably at least 5 µm, more preferably between 5-50 µm and especially preferably between 10-40 µm. The depth of the channels corresponds at least to the thickness of the front conductor 4 but typically exceeds such thickness, for example, by at least 1% in order to reliably isolate the sensor conductor 7 and the superguard conductor 5 against each other and against the front conductor 4. Such channels which are also referred to above and below as void lines, at least partly surround the sensor conductor 7 and, if present, the superguard conductor 5 thereby defining the geometry of such conductors. The zones may be essentially linear but curved and/or polygonic shapes, combinations of these or more complicated shapes are also possible. Any such shapes are easily accessible within the present invention which therefore allows to improve and/or tailor-make the sensitivity to the capacitive sensor film to an extent not available so far.

The removal of the front conductor 4 in the zones at least partly surrounding the sensor conductor 7 can be accomplished by several methods.

In a first method which is preferred the front conductor 4 is removed in said zones by laser ablation. In one illustrative embodiment this method utilizes diode-pumped or lamp-pumped solid-state lasers such as, for example, Nd:YAG, Nd:YVO₄, Nd:GdVO₄ or Nd:YLF lasers. It is also possible to use gas lasers such as, for example, CO₂ lasers. The output of such lasers is typically pulsed so that a specific laser emits energy pulses at a predetermined frequency. The laser beam may be moved along a desired path by a reflecting galvanometer mirror in order to create, for example, the zones and, preferably, void lines surrounding the sensor conductor 7 or the superguard conductor 5 when the front conductor 4 is removed. Along such path the laser is focused at a first point in time at a first desired spot, and a first energy pulse is released. If the output power of the laser is chosen appropriately the front conductor (e. g. a metal layer of a certain thickness comprising aluminium or copper) is evaporated in such first spot thereby exposing the underlying layer such as, for example, the front major surface 2b of the backing layer 2 or an underlying adhesive layer 3. The laser power required depends on several parameters including, in particular, the thickness of the front conductor layer 4 and the material of the front conductor layer 4. The laser power can easily selected by the person skilled in the art in view of such parameters and is frequently chosen to be between 5 and 250 W/cm². The width of the spots created by the laser pulses can be varied by varying the aperture of the laser and thus the pulse width. The pulse width is preferably chosen to be at least 5 µm, more preferably at least 40 µm and especially preferably at least 50 µm.

The first laser pulse thus creates a void in the front conductor at a first desired spot. Then the galvanometer mirror system deflects the laser beam to a second desired spot where a second pulse is emitted and so on. It is required to tune the laser ablating system so that the speed of the laser beam along the desired path and the pulse frequency of the laser are aligned to provide the desired overlap between adjacent spots and consequently a continuous zone between the front conductor 4 and the sensor conductor 7 or the superguard conductor 5, if present, respectively, where the front conductor 4 is removed. If the laser pulse frequency is slower than the speed of the laser beam along the desired path discrete unconnected spots are obtained so that the sensor conductor 7 and, if present, the superguard conductor 5 are not reliably electrically isolated against each other in said zones. If the laser pulse frequency is higher than the speed of the laser beam along the desired path multiple burns over the same spot will occur which may result in damaging the underlying layer or layers.

The required alignment of laser pulse frequency and linear speed of the laser beam along the desired path can easily be obtained by the person skilled in the art. The linear speed of the laser beam preferably is at least 300 mm/s and more preferably at least 400 mm/s. The linear speed of the laser beam is more preferably between 400 and 5,000 mm/s and, in particular, between 500 and 4,000 mm/s.

Further details on ablation-type laser systems can be taken, for example, from US 2005/0,257,708.

The material of the front conductor 4 can be removed in the zones at least partly surrounding the sensor conductor 7 and, if present, the superguard conductor 5 by various other techniques comprising, for example, mechanical abrasion, plasma ablation, ion sputtering or chemical etching. In an exemplary abrasion technique a thin rotating pin comprising a tip with abrasive properties may be moved along a desired path through the front conductor 4 in order to abrade the material of the front conductor 4 in the zone along said path. The abrasive tip may have various shapes such as, for example, a spherical, cylindrical or conical shape, and its dimensions are preferably selected so that the width of said zones or void line formed in the front conductor 4 is at least 25 µm and more preferably at least 50 µm. When moved along said desired path, the abrasive tip is introduced into the front conductor 4 and, if necessary, into the underlying layer at a depth sufficient to reliably remove the material of the front conductor in said zone and exposing the front major surface 2b of the backing layer 2 and/or the adhesive layer 3. In another specific mechanical abrasion method the exposed major surface of the front conductor 4 may be impinged by an optionally pulsed water jet. The front conductor 4 may also be removed in said zones by other techniques including chemical etching or plasma ablation.

The guard conductor 1, the front conductor 4, the sensor conductor 7 and, if present, the superguard conductor 5 of the capacitive sensor film 50 of the present invention are preferably electrically contacted from one of the major surfaces of the film or at the edge of the film. The term edge of the film denotes its circumferential extension in the direction of its thickness. The rear major surface of the film 50 may be formed by the exposed surface of the guard conductor, the rear major surface 2a of the backing layer or, if present, by the exposed surface of the rear protective layer 17. The front major surface of the film 50 may be formed by the front major surface 2b of the backing layer 2 or the exposed surfaces of the front conductor 4, the sensor conductor 7 or the superguard conductor 5, respectively, or, if present, by the exposed surface of the front protective layer 16. In a preferred embodiment the capacitive sensor film 50 of the present invention comprises at least one through-going hole 10 extending through the backing layer 2 to one of the major surfaces of the film 50. In case electrical connections are made to the capacitive sensor film 50 from its rear major surface , the sensor conductor 7 and, if present, the superguard conductor 5 may be contacted through such one or more through-going holes 10, Likewise, in case the film 50 is electrically contacted from its front major surface, the guard conductor 1 may be contacted through such one or more through-going holes 10.

It is preferable to provide at least one through-going hole 10 allowing to electrically connect the guard conductor 1 and the front conductor 4.

The one or more through-going holes 10 may be applied by any punching or die-cutting device such as, for example, by a pneumatic or mechanical hole punch, machined die or rotating block. The cross-section of the through-going holes 10 may have any shape including, for example, a circular, ellipsoidal, rectangular or irregular shape. The cross-sectional dimension of the through-going holes 10 is not critical and is selected to allow for a reliable electrical connection while not adversely affecting the integrity of the capacitive sensor film. Preferably the cross-sectional dimension of the through-going holes varies between 0.2 and 5 cm² and more preferably between 0.5 and 2.5 cm².

The one or more through-going holes 10 may or may not extend through the guard conductor 1, sensor conductor 7, the front conductor 4 and, if present, the superguard conductor 5. When a metal film or foil is used, for example, as the front conductor 4 the one or more through-going holes 10 preferably extend to the rear surface of the corresponding conductor but do not extend through such conductor. In this embodiment the rear surface of the sensor conductor 7, the front conductor 4 and, if present, the superguard conductor 5 can be easily contacted through the one or more through-going holes 10 from the rear surface of the film.

Alternatively it is also possible that the one or more through-going holes 10 extend through the corresponding conductor so that the front surface of the sensor conductor 7, the front conductor 4 and/or the superguard conductor 5 can be contacted through the one or more through-going holes 10 from the rear side of the film. In such case, one or more auxiliary conductors 12 may be provided which are electrically connected to the sensor conductor 7, the front conductor 4 and/or, if present, to the superguard conductor 5. The auxiliary conductors 12 may be formed, for example, by electrically conductive adhesive tapes comprising a backing 15 bearing an electrically conductive adhesive 14. A strip of such tape is attached via its electrically conductive adhesive layer to the corresponding conductor, and the length of such adhesive strip is selected so that it extends into the area of the through-going hole 10. Thus, the corresponding conductor can be electrically connected from the rear side of the capacitive sensor film 50 via such auxiliary conductive adhesive strip.

The auxiliary conductors 12 may also be formed by metal foils or carrier films bearing a metal coating layer obtained, e. g., by vacuum metal vapour deposition. Such conductors 12 are applied so that the metal foil or the metal coating layer contacts the sensor conductor 7, the front conductor 4 and/or, if present, the superguard conductor 5, and they may be held in place, for example, by conventional one-sided adhesive tapes.

The backing 15 of an electrically conductive adhesive tape which can be used as auxiliary conductor 12, may include electrically conductive and non-conductive materials such as metal films or polymeric films. Conductive film tapes comprising an aluminum or copper foil backing, respectively, bearing in each case an electrically conductive pressure-sensitive adhesive, are commercially available from 3M Company, St. Paul/MN, USA, under the trade designations "3M 1170 EMI Aluminium Foil Shielding Tape" and "3M 1181 EMI Copper Foil Shielding Tape", respectively. An aluminum foil having a thickness of 20 µm which can be used as the backing 15 of an auxiliary conductor 12, is available, for example, from Tesco Comp. under the designation "cooking foil".

The auxiliary conductor 12 may generally be formed by any material which can be attached to the sensor conductor 7, to the front conductor 4 and/or, if present, to the superguard conductor 5 in an electrically connecting way and which is sufficiently self-supporting so that it provides a reliable electrical contact zone within the area of the through-going hole 10. The auxiliary conductor 12 may also be formed, for example, by an optionally flattened metal wire which is attached to the corresponding conductor by means of an electrically conductive adhesive.

If desirable, an electrically insulating film 11 may be applied to fully cover the one or more through-going holes 10 on the front and/or rear side of the backing layer 2, respectively, before applying the auxiliary conductors 12. Such electrically insulating film 11 comprises a backing (not designated by a reference number in the below figures) which may be formed, for example, by any non-conductive polymeric or paper film. Useful non-conductive polymeric materials include, for example, polyolefin polymers, monoaxially oriented polypropylene (MOPP), biaxially oriented polypropylene (BOPP), simultaneously biaxially oriented polypropylene (SBOPP), polyethylene, copolymers of polypropylene and polyethylene, polyvinylchloride, copolymers having a predominant olefin monomer which may optionally be chlorinated or fluorinated, polyester polymers, polycarbonate polymers, polymethacrylate polymers, cellulose acetate, polyester (e. g. biaxially oriented polyethylene terephthalate), vinyl acetates, and combinations thereof. The backing of the electrically insulating film 11 preferably bears an adhesive layer 6 and, in particular, a pressure-sensitive adhesive layer on one of its major surfaces through which it is attached to the front and/or rear side of the capacitive sensor film 50 thereby covering the through-going holes 10. Then, holes are punched through the one or more electrically insulating films so that the through-going hole 10 is restored which now additionally extends through the insulating films. Preferably, the cross-sectional extension and/or shape of the holes punched into the electrically insulating films are selected so that the hole punched through the insulating film is smaller than the through-going hole punched originally. The edges of the electrically insulating films 11 extending into the area of the through-going hole 10, bond to the inner wall of the through-going hole 10 thereby electrically insulating the guard conductor 1 from the sensor conductor 7, the front conductor 4 and, if present, from the superguard conductor 5. In a preferred embodiment the length of the edges of the electrically insulating films 11 extending into the zone of the through-going hole 10, is selected so that the inner wall of the through-going hole is essentially fully covered by the electrically insulating films 11. This specific design reliably insulates the guard conductor 1 from the sensor conductor 7, the front conductor 4 and, optionally, the superguard conductor 5 and additionally reinforces the area of the through-going hole 10. Electrically insulating films 11 are preferably applied both to the front major surface of the film 50 (i.e. onto the front conductor 4, the sensor conductor 7, the superguard conductor 5 and/or the exposed front major surface 2b of the backing layer) and to the exposed rear major surface of the film 50 including the guard conductor.

The above preferred embodiment has been described for the case that the capacitive sensor film 50 is contacted from its rear major surface.

It is, however, also possible that the capacitive sensor film 50 is contacted from its front major surface. In such case the one or more through-going holes 10 will extend from the front major surface to the front surface of the guard conductor 1 or through the guard conductor to its rear surface, respectively. If the guard conductor does not fully cover the rear major surface 2a of the backing 2 and the one or more through-going holes are arranged outside the area of the guard conductor 1, one or more auxiliary conductors 12 and, if desirable, one or more insulating films 11 may optionally be used as was described above to allow for an easy and reliable connection.

In another embodiment the film 50 is electrically connected at its edge.

In a preferred embodiment the sensor conductor 7 and the guard conductor 1 each comprise at least one edge area or portion which are adjacent to each other and to the edge of the film 50. The term "adjacent to the edge" means that such edge areas or portions extend close to the edge of the film so that such areas or portions can be easily contacted, for example, by means of a socket attached to the edge of the film 50. In case the capacitive sensor film 50 comprises a superguard conductor 5, or if the front conductor 4 and the guard conductor are to be electrically connected these conductors 4, 5 preferably also exhibit edge areas or portions adjacent to those of the sensor conductor and the guard so that the electrical connections to such conductors 1,7,5 and/or 4 can be easily integrated, for example, into a socket.

Further details on electrically connecting the capacitive sensor films 50 of the present invention can be taken from the co-pending European patent application with the title "Proximity sensor and method for manufacturing the same" which was filed by the present applicant on January 19, 2006.

In some applications it is desirable to seal the capacitive sensor film 50 between protective films 16, 17 to protect the capacitive sensor film 50 against environmental impacts such as water or moisture, to electrically insulate the film 50 and/or to render it more easily handleable. Such protective films are preferably selected from the group of polymeric films, layers and laminates. Useful polymers include, for example, polyolefin polymers, monoaxially oriented polypropylene (MOPP), biaxially oriented polypropylene (BOPP), simultaneously biaxially oriented polypropylene (SBOPP), polyethylene, copolymers of polypropylene and polyethylene, polyester polymers, polycarbonate polymers, polymethacrylate polymers, cellulose acetate, polyester (e. g. biaxially oriented polyethylene terephthalate), vinyl acetates, and combinations thereof.

The protective polymer films may be applied to the front major surface 2b of the backing layer bearing the sensor conductor 7, the front conductor 4 and, optionally, the superguard conductor 5 and to the guard conductor 1 on the back major surface 2a of the backing 2 by adhesive means including, for example, hotmelt adhesives and pressure-sensitive adhesives. The length and width of the protective films 16, 17 preferably exceeds the length and width of the backing film 2 and/or the guard conductor 1 to provide an edge sealing to the capacitive sensor film 50 to protect, in particular, the edges of the guard conductor against corrosion. The length and width of the protective films 16, 17 is preferably selected to provide an edge sealing border with a width of 1 - 50 mm, more preferably of 1 - 40 mm and especially preferably of 2 - 20 mm.

In case the capacitive sensor film 50 is contacted at one of its edges the protective films 16, 17 may be removed in the edge areas or portions of the conductors 1, 4, 5 and/or 7 adjacent to the edge subsequent to applying such films 16, 17. Alternatively, the protective films 16, 17 may be approximately shaped prior to lamination so that such edge zones or portions are not covered by the protective film upon lamination.

In case the capacitive sensor film 50 is contacted via one or more through-going holes 10 these may be punched into the protective film 16, 17 on the major surface of the capacitive sensor film 50 from which the capacitive sensor film 50 is contacted thereby extending the through-going holes to such surface. In case the capacitive sensor film 50 is contacted from its rear major surface a further hole may be punched into the protective film 17 to allow for contacting the guard conductor 1. Likewise, in case the capacitive sensor film 50 is contacted from its front major surface, one or more additional holes may be punched into the protective layer 16 to allow for contacting the sensor conductor 7, the front conductor 4 and, optionally, the superguard conductor 5 whereas the guard conductor 1 is contacted via one or more through-going holes 10.

Alternatively, one or more holes can be punched at appropriate locations into the protective film 16, 17 prior to lamination so that such pre-punched holes extend the through-going hole or holes 10 to the respective major surface of the capacitive sensor film 50 and/or provide access to the desired conductors 1, 7, 4 and/or 5.

In case the capacitive sensor film 50 is contacted at one of its edges connecting cables or strips are supplied into such edge region and pressed against the guard conductor 1, the sensor conductor 7 and, optionally, the superguard conductor 5 and/or the front conductor 4 to establish electrical contact. Pressure can be applied, for example, via spring loaded pads which continuously press on the connection zones between the conductors 1, 7, 4 and/or 5 and the connections strips.

Likewise, in the case the capacitive sensor film 50 if contacted from one of its major surfaces, connecting cables or strips are supplied through the one or more through-going holes 10 or through the additional holes which may be present to contact the guard conductor 1, the sensor conductor 7 and, optionally, the superguard conductor 5, the front conductor 4 and/or any auxiliary conductors 12 which may be attached to conductors 1, 7, 4 and/or 5. If the capacitive sensor film 50 is contacted, for example, from its rear major surface, connection strips are supplied from the rear side of the capacitive sensor film 50 through the one or more through-going holes 10 and pressed against the sensor conductor 7, the superguard conductor 5, the front conductor 4 and/or the auxiliary conductors 12, respectively to establish electrical contact. Pressure can be applied, for example, via spring loaded pads which continuously press on the connection areas between the connectors and the sensor conductor 7, the superguard conductor 5, the front conductor and/or the auxiliary conductors 12, respectively.

In a preferred embodiment, the one or more through-going holes 10 may be filled with a conductive ink such as a silver ink which is subsequently solidified by evaporative drying or curing. The through-going hole 10 may also be filled, for example, with a precursor of a silver epoxy adhesive which is thermally cured upon insertion into the one or more through-going holes 10. In these constructions the connecting strips do not need to be supplied through the through-going holes 10 but can be applied, for example, at the respective major surface of the capacitive sensor film 50. Establishing of electrical contact between the connectors and the sensor conductor 7, the superguard conductor 5, the front conductor 4 and/or the auxiliary conductors 12 is thus facilitated, and the resulting connection is more reliable and mechanically stable.

The capacitive sensor film 50 of the present invention can thus easily and reliably be electrically contacted from one of its major surfacesor from its edge respectively. Contacting the capacitive sensor film 50 from one of its major surfaces and, in particular, from its rear major surface is particularly preferred in automotive applications.

It is usually desirable to integrate the connectors contacting the guard conductor 1, the sensor conductor 7 and, optionally, the front conductor 4, the superguard conductor 5 and/or the auxiliary conductors 12 in a socket body which may be applied to the capacitive sensor film 50 to allow for a standardized connection. When applied to one of the major surfaces or to the edge of the capacitive sensor film 50 respectively, a complete hermetic seal is preferably formed between the periphery of the socket body and the capacitive sensor film 50 or thus preventing water, air or dust ingress into the inner layers or the connection area. In a preferred embodiment the socket body comprises sealing means such as sealing O rings or adhesive gaskets around its periphery contacting the capacitive sensor film 50. The socket body is applied to the capacitive sensor film 50 so that the sealing O rings or the adhesive gaskets are pressurized and form the required hermetic seal.

The capacitive sensor film 50 of the present invention may be advantageously used in automotive applications for sensing the proximity of a car to other objects where it can be introduced, for example, in the rear and front bumper. The present inventions allows to widely vary the shape and geometry, in particular, of the sensor conductor 7 and the superguard conductor 5 thus allowing to improve the sensitivity of the capacitive sensor films 50 of the present invention or to adapt and tailor-make it for specific applications. The present invention furthermore allows to increase the effective area of the guard conductor 1 by electrically combining the guard conductor 1 on the rear major surface 2a of the backing layer with the front conductor 4 on the front major surface 2b of the backing layer. The capacitive sensor film 50 can be cut into the required shape by any die-cutting, punching or laser cutting means, for example. Due to its flexibility it can be easily processed and bent into conformity with the bumper shape, if required. It is particular advantageous that the capacitive sensor film 50 can be easily electronically connected from its rear side which does not only facilitate assembling at the OEM (original equipment manufacturer) site but also allows, for example, for an easy replacement of such capacitive sensor film 50 if the bumper incorporating it is damaged in an accident.

The capacitive sensor films 50 of the present invention can be easily installed and they are flexible so that they can be applied to shaped substrates having, for example, curved surfaces. It is particularly advantageous that the capacitive sensor films 50 can be electrically contacted in an easy and reliable way. In view of these advantages the capacitive sensor films 50 of the present invention are especially suited for use in the automotive industry.

Devices which are suitable for measuring and processing signals of the sensor conductor 7 have been disclosed, for example, in WO 02/19,524 and are not further described here.

In a preferred method of manufacturing a capacitive sensor film 50 of the present invention which may be contacted from one of its major surfaces, an aluminium film laminate comprising the backing layer 2 bearing an aluminium layer which forms the guard conductor 1, is provided first. Then a front conductor 4 is applied to the opposite major surface of the backing. The front conductor 4 may be a metal film or foil bonded, for example, by adhesive means. Alternatively, the front conductor 4 may also be applied by vacuum metal vapour coating.

Then the sensor conductor 7 and, optionally, the superguard conductor 5 are formed within the front conductor by removing the front conductor 4 in zones at least partly surrounding the sensor conductor 7 and the guard conductor 5 as was described above.

### Detailed description of the figures

The following figures are schematic and are not drawn to scale.

Fig. 1 shows a top view of a first embodiment of a capacitive sensor film 50 of the present invention comprising a front conductor 4 surrounding a sensor conductor 7 and a superguard conductor 5. The front conductor 4 is separated from the superguard conductor 5 and the sensor conductor 7, respectively, by zones or void lines in which the front conductor 4 is removed so that the front major surface 2b of the backing layer 2 is exposed. This ensures that the superguard conductor 5 and the sensor conductor 7, respectively, are electrically isolated against each other and against the front conductor 4. The superguard conductor 5 comprises one strip extending essentially along the length of the film 50. The sensor conductor 7 exhibits a more complicated design and comprises four strips essentially extending along the length of the film 50. At both lateral ends the sensor conductor comprises three shorter additional strips each to provide lobe type end regions in order to increase the sensitivity of the sensor conductor at its lateral end regions. The upper longitudinal edge of the film 50, the superguard conductor strip 5 and the strips of the sensor conductor 7 are essentially parallel to each other. The different strips of the sensor conductor 7 are electrically connected at both end regions by a further strip each extending transversely inclined to the longitudinal direction of the film 50.

Fig 1 a shows an enlarged top view of the left part of a second embodiment of a capacitive sensor film 50 of the present invention which is slightly modified in comparison to the sensor film of Fig. 1 in that the superguard conductor 5 and the top-most strip of the sensor conductor 7 each additionally comprise a connection area 8 which may be used for electrically connecting such conductors. The connecting area 8 of the superguard conductor 5 is essentially square whereas the connecting area 8 of the sensor conductor 7 has an essentially rectangular shape in order to facilitate, for example, the application of the through-going holes 10, the insulating tapes 11 and the auxiliary connector strips 12 in the embodiment shown in Fig. 3a-c below. The connecting areas 8 can be arranged anywhere on the front major surface of the film 50 and do not need to be positioned at its left part.

Figs. 2 and 2a are cross-sectional views of two different embodiments of the capacitive sensor film 50 of Fig. 1a along the line A-A indicated in Fig. 1 a differing in the extension of the guard conductor 1 along the line A-A. In the embodiment of Fig. 2 the guard conductor 1 extends over the full width of the capacitive sensor film 50 whereas in the embodiment of Fig. 2a the extension of the guard conductor 1 is selected to essentially match that of the superguard conductor 5 and the sensor conductor 7, Both cross-sectional views of Figs. 2 and 2a show that the front conductor 4 has been removed in the void lines between such front conductor 4 on the one hand and the superguard conductor 5 and the different strips of the sensor conductor 7, respectively, on the other hand; the Figures are highly schematic and do only show the cross-section of three conductive strips of the sensor conductor 7 in order to avoid unnecessary complexity and to make the easier understandable. The front conductor 4, the superguard conductor 5 and the sensor conductor 7 are borne by the front major surface 2b of the backing layer 2. The guard conductor 1 is attached to the rear major surface 2a of the backing layer 2 via the adhesive layer 3.

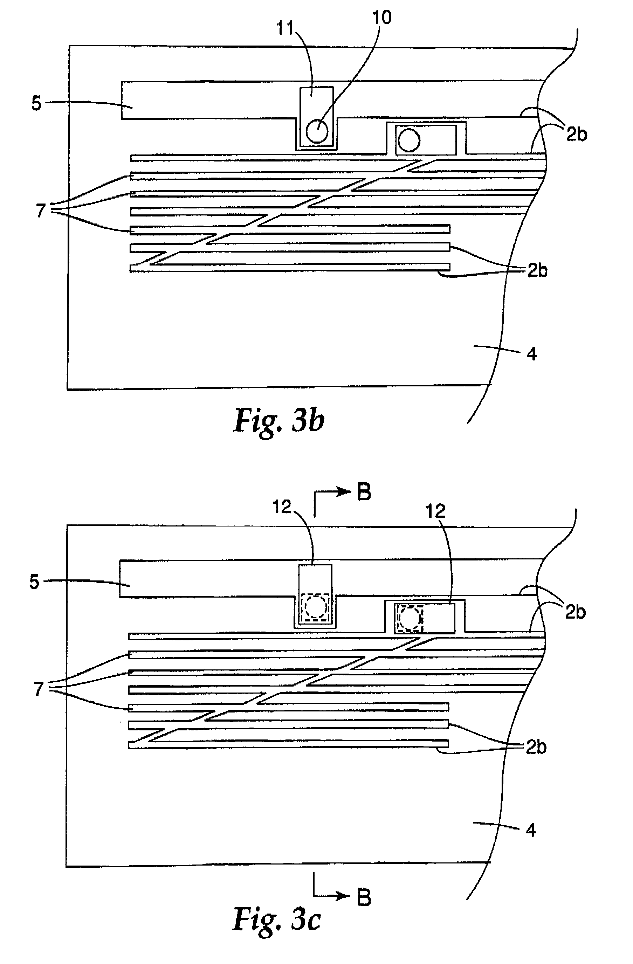

Figs. 3a - 3c show a process of applying through-going holes 10 to the film 50 so that such film can be electrically connected from its rear major surface. Fig. 3a shows the top view of the left part of the capacitive sensor film 50 of Fig. 1 a additionally where two through-going holes 10 have been applied in the connecting areas 8 of the superguard conductor 5 and the top-most strip of the sensor conductor 7, respectively. In Fig. 3b an electrically insulating film 11 has been applied covering the through-going holes 10. Subsequently holes have been punched into the electrically insulating film to re-expose the through-going holes. In Fig. 3c auxiliary conductors 12 are attached so that they cover the through-going holes 10 and the electrically insulating film 11.

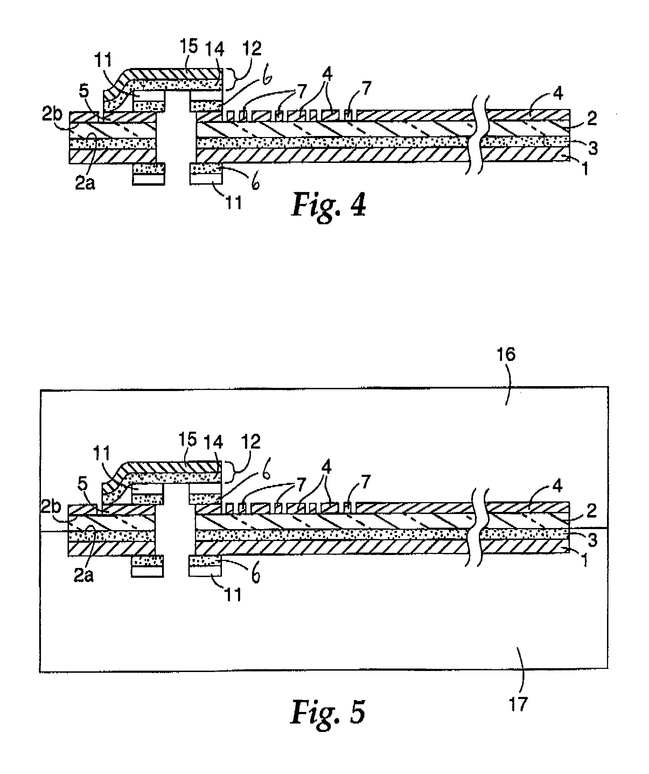

Figs. 4 and 5 are cross-sectional views of the capacitive sensor film 50 of Fig. 3c along the line B-B indicated in Fig. 3c. The same remarks relative to the number of the strips of the sensor conductor 7 as given above in connection with Fig. 2 and 2a apply here, as well. The through-going hole 10 shown in the cross-sectional view of Fig. 4 extends from the front major surface of the superguard conductor 5 to the rear major surface of the guard conductor 1. Insulating tapes 11 have been applied at both ends of the through-going hole 10 whereby the diameter of the holes punched into the insulating tapes 11 is in each case smaller than the diameter of the through-going hole 10. The portion of the insulating tape 11 extending into the zone of the through-going hole is bent around and attached to the inner walls of the through-going hole 10 thereby avoiding a short circuit between the superguard conductor and the guard conductor 1. A strip of a conductive tape 12 is applied on top of the insulating film 11 so that the superguard conductor 5 can be contacted from the rear side of the film 50. Fig. 5 is the cross-sectional view of the capacitive sensor film 50 of Fig. 4 additionally comprising two protective layers 16, 17.

Fig. 6 is the top view of a capacitive sensor film 50 similar to the embodiment of Fig. 3c which comprises a further through-hole 10 covered with an auxiliary conductor 12 which is arranged in the area of the front conductor 4 between the connecting areas 8 of the sensor conductor 7 and the superguard conductor 5, respectively.

Fig. 6a is a cross-sectional view of the capacitive sensor film 50 of Fig. 6 along the line C-C indicated in Fig. 6. The through-going hole 10 extends from the front major surface of the front conductor 4 to the rear major surface of the guard conductor 1. A strip of a conductive tape 12 is applied on top of the front conductor 4 so that the front conductor 4 and the guard conductor 1 can be jointly contacted from the rear side of the of the film 50. The same remarks relative to the number of the strips of the sensor conductor 7 as given above in connection with Fig. 2 and 2a apply here, as well.

The present invention is further illustrated in the following non-limiting Examples,

### Examples

### Example 1

A 12 µm thick polyethyleneterephthalate (PET) film (length 1.5 m, width 325 mm,) bearing on one of its major surfaces an electrically conductive aluminium vapour coating layer with a thickness of 0.3 µm (obtainable from Amcor, UK) was laminated onto a 100 µm PET film bearing a 25 µm ethylenevinylacetate (EVA) adhesive layer so that the aluminium vapour coat layer forming the front conductor 4 was exposed and the EVA adhesive layer bonded the two PET layers. The PET film bearing the adhesive layer was available from GBC, UK. The lamination was performed using a CATENA 35 laminator, available from GBC, at about 1m/min speed with a roller temperature of about 110°C.

The resulting film was placed into a flat bed on an XY table below a YAG laser head. The laser system used had a power of 90 Watt. The source was a continuous wave, lamp-pumped Nd:YAG laser (1064 m). The output of the laser was Q-switched to produce pulsed emission. The laser was coupled with a Galvo-head with X and Y mirrors and a 300 mm flat-field lens to keep the spot in focus at the edge as well as at the centre of the path along which the void line was formed. Distortion of the image through the lens was compensated for in the controlling software. The settings used were:
- aperture: 1375 mm
- Q-switch (pulse) frequency: 10 kHz
- Lamp current: 13 amp
- Speed : 400 mm/sec
- Delay at beginning and end of etch lines : 30 msec

A conductor circuit as shown in Fig. 6 was obtained on the aluminium side of the film. The black lines in Fig 6 represent the void lines, i.e. the zones where the aluminium has been removed. The white zones represent the remaining aluminium which forms the superguard conductor 5, the sensor conductor 7 and the front conductor 4.

The wider strip which s arranged above the series of smaller strips and has a width of 12 mm is the superguard conductor 5. It comprises a contact zone for applying a through-going hole 10 and extends along the length of the film. The seven smaller strips below which are connected to each other form the sensor conductor 7. The distance between the superguard conductor 5 and the sensor conductor was -outside the contact zone- 20 mm. The overall length of the upper four strips of the sensor conductor 7 was 1,44 m each whereas the three lower strips each had a length of 0.2 m on each side; the overall geometry of the film of Fig. 6 was symmetrical and exhibits three lower strips on both sides of the film similar to the geometry shown in Fig. 1. The strips of the sensor conductor 7 each had a width of 0.5 mm and the distance between the Istrips was 5 mm. The connection zone of the superguard conductor 5 was essentially square with a width of 12mm. The connection zone of the guard conductor 7 was rectangular and had a width of about 12 mm and a length of about 25 mm. The connection zone of the superguard conductor was arranged at a distance of about 140 mm from the left edge of the superguard conductor 5. The distance between the connection zones of the supeguard conductor 5 and the sensor conductor 7, respectively, was about 15.mm. The capacitance between the sensor conductor 7 and the superguard conductor 5 was measured using a conventional capacitance meter. A value of 0.77 nF was recorded

Then, three through-going holes 10 with a diameter of about 8 mm were punched through the film in each of the two connection zones and in the zone inbetween as is shown in Fig. 6. A 10mm square piece of conductive tape (carbon fibre filled adhesive transfer tape 9713, available from 3M which was laminated to 7 µm thick aluminium foil strip available from Novelis, UK), was laid over each of the holes on the front side of the film comprising the esxposed sensor conductor 7, superguard conductor 5 and front conductor 4, ensuring that the tape was in contact with the corresponding conductor in the respective zone but did not overlap with any adjacent conductor.
On the rear side of the film, a 70 mm wide strip of aluminium foil tape (available from 3M as tape 425 or similar) was applied as a guard conductor 1 as is shown in Fig. 6a so that it extended in the width direction from the upper edge of the film; the width of the aluminium foil tape was chosen so that it matched the extension of both the superguard conductor 5 and the sensor conductor on the other major side of the film. The aluminium foil tape extended in length direction along the length of the film. The aluminium foil guard conductor 1 tape holes exhibited holes matching the position of the through-going holes 10 so that such holes were exposed on the rear side of the film. Fig. 6a shows the through-going hole extending from the front conductor zone 4 between the connection zones on the sugerguard conductor and the sensor conductor 7, respectively, on the front major surface to the guard conductor 1 on the rear major surface of the film. The holes in the aluminium foil guard conductor tape on the rear major surface of the film corresponding to the through-going holes emanating from the connection zones of the sensor conductor 7 and the super guard conductor 5, respectively, were made larger than the diameter of the through-going holes so that no electrical connection was obtained between the guard conductor 1 on the one hand and the sensor conductor 7 and the superguard conductor 5, respectively, on the other hand. The through-going holes 10 were filled with a conductive ink so that the film could be contacted from the rear side.

The whole capacitive sensor film 50 was then cut to the required- shape using a clear acrylic plastic template.

The capacitive sensor film thus obtained was then laminated between two layers of DK 951 PP polypropylene laminating tape acting as protective layers 16,17.. In an alternative embodiment, two layers of heat seal protective polyester film (50 µ PET film with 25µ EVA heat seal adhesive, available from GBC, UK) were used.

Appropriate holes were cut into the protective film 17 applied to the rear side of the capacitive sensor film in order to expose the through-going holes.

The capacitive sensor film was then trimmed to shape and a connector was applied to make the electrical contacts.

### List of reference numbers

- 1: guard conductor
- 2: backing layer
- 2a: rear major surface of the backing layer 2
- 2b: front major surface of the backing layer 2
- 3: adhesive layer
- 4: front conductor
- 5: superguard conductor
- 6: adhesive layer
- 7: sensor conductor
- 8: connector areas
- 10: through-going hole
- 11: electrically insulating film
- 12: auxiliary conductor
- 14: electrically conducting adhesive layer
- 15: backing layer
- 16: front protective layer
- 17: rear protective layer
- 50: capacitive sensor film

## Claims

1. A capacitive sensor film (50) for mounting to a body comprising a backing layer (2) having a rear major surface (2a) facing, in use, the body and a front major surface (2b) opposite to said rear major surface (2a), said rear major surface (2a) bearing a guard conductor (1) and said front major surface (2b) bearing a front conductor (4) at least partly surrounding a sensor conductor (7) which is electrically isolated against the front conductor (4) by zones where the front conductor (4) is removed and the front major surface (2b) of the backing layer (2) or another layer beneath the front conductor (4) is exposed.

2. A capacitive sensor film (50) according to claim 1 wherein the front conductor (4) is a metal film bonded to the front surface (2b) of the backing layer (2) with an adhesive layer (3) or is applied to the front surface (2b) of the backing layer (2) by metal vapour coating.

3. A capacitive sensor film (50) according to any of the preceding claims wherein the zones are elongate channels having a width of at least 5 µm

4. A capacitive sensor film (50) according to any of the preceding claims having a depth of at least the thickness of the front conductor (4).

5. A capacity sensor film (50) according to any of the previous claims wherein the sensor conductor (7) forms a continuous or discontinuous metal zone or zones whereby the discontinuous zones are electrically connected.

6. A capacity sensor film (50) according to claim 5 wherein the zones where the front conductor (4) is removed is selected so that the sensor conductor (7) is an elongated strip.

7. A capacity sensor film (50) according to claim 5 wherein the zones where the front conductor (4) is removed is selected so that the sensor conductor (7) comprises two or more separate elongated strips which are electrically connected.

8. A capacitive sensor film (50) according to any of the previous claims wherein said front surface (2b) additionally bears a superguard conductor (5) which is electrically isolated against the front conductor (4) and the sensor conductor (7) by zones where the front conductor (4) is removed.

9. A capacitive sensor film (50) according to any of the previous claims wherein the front conductor (4) and the guard conductor (1) are electrically connected.

10. Method of manufacturing a capacitive sensor film (50) according to claims 1 - 9 comprising
(i) providing a backing layer (2),
(ii) applying a guard conductor (1) to the rear major surface (2a) of the backing layer (2),
(iii) applying a front conductor (4) to the front major surface (2b) of the backing layer (2),
(iv) providing a sensor conductor (7) by mechanically abrading zones of said front conductor (4) at least partly surrounding said sensor conductor (7) to electrically isolate the sensor conductor (7) from said front conductor (4) thereby exposing the front major surface of the backing layer (2b) or another layer beneath the front conductor (4) in said zones.

11. Method of manufacturing a capacitive sensor film according to claims 1 - 9 comprising
(i) providing a backing layer (2),
(ii) applying a guard conductor (1) to the rear major surface (2a) of the backing layer (2),
(iii) applying a front conductor (4) to the front major surface (2b) of the backing layer (2),
(iv) providing a sensor conductor (7) by removing zones of said front conductor (4) at least partly surrounding said sensor conductor (7) by laser ablation to electrically isolate the sensor conductor (7) from said front conductor (4) thereby exposing the front major surface of the backing layer (2b) or another layer beneath the front conductor (4) in said zones.
